# EUROPEAN PATENT SPECIFICATION

(11) **EP 1 998 153 B1**
(45) Date of publication and mention of the grant of the patent: **03.06.2020**
(21) Application number: 07738967.4
(22) Date of filing: 19.03.2007
(51) Int. Cl.: G01J 5/34, H01L 37/02

(54) **CURRENT PYROELECTRIC INFRARED SENSOR**
PYROELEKTRISCHER INFRAROT-STROMSENSOR
CAPTEUR INFRAROUGE PYROELECTRIQUE A COURANT

(30) Priority: 20.03.2006 JP 2006077320
(43) Date of publication of application: 03.12.2008
(73) Proprietor: DAIKIN INDUSTRIES, LTD., Osaka-shi, Osaka 530-8323 (JP)
(72) Inventor: ISHIDA, Kenji, Hyogo 657-8501 (JP); KUWAJIMA, Shuichiro, Kyoto-shi Kyoto 606-8501 (JP); MATSUSHIGE, Kazumi, Kyoto-shi Kyoto 606-8501 (JP); HORIUCHI, Toshihisa, Kyoto-shi Kyoto 606-8501 (JP); MATSUMOTO, Arifumi, Toyota-shi, Aichi 470-1206 (JP); KODANI, Tetsuhiro, Settsu-shi Osaka 566-8585 (JP); KOH, Meiten, Settsu-shi Osaka 566-8585 (JP)
(74) Representative: Hoffmann Eitle
(86) International application number: PCT/JP2007/055522
(87) International publication number: WO 2007/108441

(56) References cited:
- GB-A- 2 020 097
- JP-A- 01 296 216
- JP-A- 07 092 025
- JP-A- 54 128 685
- JP-A- 2004 037 291
- JP-A- 2005 136 325
- JP-U- 02 081 427

## Description

### TECHNICAL FIELD

The present invention relates to a pyroelectric infrared sensor using a material having pyroelectrical property.

### BACKGROUND ART

A pyroelectric infrared sensor is an infrared sensor using a pyroelectric material having property that an amount of spontaneous polarization inside a substance is changed depending on temperature. In this pyroelectric infrared sensor, a change in an amount of spontaneous polarization generated due to temperature rise caused by absorption of infrared rays by the pyroelectric material is taken out in the form of electric signal to detect presence or absence of infrared rays and intensity thereof.

In order to improve sensitivity of a pyroelectric infrared sensor, it is desirable that a pyroelectric material has (i) a high pyroelectric coefficient, (ii) a small heat capacity, and (iii) a low dielectric constant. The pyroelectric coefficient is defined by a change in polarization due to a change in unit temperature per unit volume. Decrease in heat capacity leads to elevation of temperature by irradiation of infrared rays even in the case of the same amount, and contributes to improvement in sensitivity of detecting infrared rays. In addition, decrease in a dielectric constant of pyroelectric material results in decrease in electrostatic capacity between the electrodes provided with the pyroelectric material between them. In this case, a large voltage appears between the both electrodes by a change in polarization, which contributes to improvement in sensitivity of infrared ray detection measured by a change in voltage.

Hitherto, pyroelectric infrared sensors having a pyroelectric material comprising an inorganic ferroelectric material such as lead zirconium titanate (PZT) or barium titanate (BaTiO₃) or a ferroelectric polymer such as polyvinylidene fluoride (PVDF) or a random copolymer (PVDF/TrFE) comprising PVDF and trifluoroethylene (TrFE), have been used. However, though inorganic ferroelectric materials have an advantage that a pyroelectric coefficient is high, since a dielectric constant and heat capacity thereof are large, there is a limit in improvement in sensor sensitivity, and in addition, there is a disadvantage that a high temperature process of about several hundred centigrade needs be employed when forming a thin film.

In JP2004-037291A ([0016] to [0024], [0032], Fig. 4), it is proposed that vinylidene fluoride oligomer (VDF oligomer) is used on a pyroelectric material of a pyroelectric infrared sensor. The VDF oligomer is represented by CF₃-(CH₂CF₂)ₙ-CₘH₂ₘ₊₁. JP2004-037291A says that polymerization degree n is 10 to 50, but actually VDF oligomers having polymerization degree n of 5 to 9 in addition to the VDF oligomers having polymerization degree of the above-mentioned range also have the following features. Therefore, in the present invention, VDF oligomers are defined as those having polymerization degree within a range from 5 to 50. Though in JP2004-037291A, only oligomers having CₘH₂ₘ₊₁ group of m=1 are described, actually oligomers of m=2 to 10 also have the following features. Further, those in which CₘH₂ₘ₊₁ group is replaced by halogen atom are also included in VDF oligomers.

VDF oligomers have a dielectric constant and heat capacity lower than those of inorganic ferroelectric materials and have the same levels of dielectric constant and heat capacity as those of ferroelectric polymers, and in addition, have a pyroelectric coefficient higher than that of ferroelectric polymers. Therefore VDF oligomers are excellent as a pyroelectric material of a pyroelectric infrared sensor. A pyroelectric coefficient of a VDF polymer varies with polymerization degree n. For example, a pyroelectric coefficient P3 of a VDF oligomer having polymerization degree n of 17 is -70 µC/m²K which is an absolute value larger than a pyroelectric coefficient P₃ of -30 µC/m²K of VDF polymer (PVDF) having a far higher polymerization degree n (n=about 1,000 to about 2,000). Also, VDF oligomers are excellent as compared with inorganic ferroelectric materials from the viewpoint that no high temperature process needs be employed when forming a thin film.

Conventional pyroelectric infrared sensors including those using VDF oligomer have a structure that a pyroelectric material is supported with a substrate comprising inorganic material such as Si. If this substrate has high heat capacity and heat conductivity, by irradiation of infrared rays, a lot of heat given to the pyroelectric material is absorbed by the substrate and is released outside from the substrate, resulting in decrease in temperature change of the pyroelectric material in irradiation of infrared rays and decrease in sensor sensitivity.

In JP2000-155050A ([0019], [0027], [0031], Fig. 1), it is disclosed that a resin substrate which is generally said to have small heat conductivity is used on a pyroelectric infrared sensor using a ferroelectric polymer as a pyroelectric material, thereby making it possible to inhibit heat given to the pyroelectric material by irradiation of infrared rays from being absorbed by the substrate and sensor sensitivity from being lowered. Further a supporter made of Si or the like is provided under the resin substrate. The resin substrate is supported with this supporter to be fixed flatly without being curved.

In GB 2 020 097 A, a pyroelectric device for detecting infrared rays incident from several directions is described, which comprises a radiation-accepting surface comprising a high polymeric film, of, for example, polyvinylidene fluoride, at least a part of said surface being curved. Electrodes are provided on both surfaces of the high polymeric film. Furthermore, the resultant pyroelectrical device is fixed to and supported by a base which may be made of either electrically insulating and thermally non-conducting material or an electroconductive material.

### DISCLOSURE OF INVENTION

In conventional pyroelectric infrared sensors, since a substrate and supporter made of inorganic materials such as Si are used, it is difficult to change forms of the pyroelectric infrared sensors depending on a shape of an installation site and location of an object to be detected.

An object of the present invention is to provide a pyroelectric infrared sensor which can change its form and has high sensitivity.

A pyroelectric infrared sensor of the present invention made to solve the above-mentioned problems is characterized by having flexibility and comprising:
a) a substrate comprising a polymer material,
b) a layer of vinylidene fluoride oligomer being formed on the substrate and comprising CF₃-(CH₂CF₂)ₙ-CₘH₂ₘ₊₁ (n=5 to 50, m=1 to 10) or a substance obtained by replacing its CₘH₂ₘ₊₁ group by halogen atom,
c) a lower electrode having flexibility and being formed between the substrate and the vinylidene fluoride oligomer layer, and
d) an upper electrode having flexibility and being formed on the vinylidene fluoride oligomer layer.

Examples of a material which can be used on the substrate are, for instance, polyimide, polyethylene terephthalate, polybutylene terephthalate, polycarbonate, polyparaphenylene sulfide and polyamide imide. For the upper electrode and the lower electrode, for example, metal deposition films such as Au, Ag, Al, Cr, Ni and Pt, carbon deposition film, and organic electrodes of polyaniline, polythiophene and PDOT-PSS can be used.

The pyroelectric infrared sensor of the present invention can be formed into a curved, cylindrical or spherical shape by making use of its flexibility. In this case, the vinylidene fluoride oligomer layer may be located at an outer side or an inner side of the curve.

These forms of sensors can be provided with means for changing a curvature of the curve (a cross section in the cases of cylindrical and spherical forms). In that case, further, means for measuring the curvature can be provided.

The substrate may be one having a bimorph configuration comprising two sheets of piezoelectric polymer films.

At least either the upper electrode or the lower electrode (or both of them) may be divided into plural pieces. In that case, it is desirable that portions of the substrate between a plurality of electrodes are eliminated.

The above-mentioned substrate is transparent to an aimed infrared ray, and a surface of the substrate corresponding to at least any of a plurality of electrodes, namely a surface of the substrate being opposite to the lower electrode and facing an infrared ray may be formed into a shape of a condensing lens such as convex lens or Fresnel lens.

### BEST MODE FOR CARRYING OUT THE INVENTION

In the present invention, the substrate made of a polymer material and the VDF oligomer layer have flexibility and the upper electrode and the lower electrode are made of materials having flexibility, and therefore, the pyroelectric infrared sensor of the present invention has flexibility. By making use of such flexibility, it is possible to obtain a pyroelectric infrared sensor formed into a shape suitable for its installation site or desired shapes such as a curved shape, a cylindrical shape and a spherical shape.

In addition, sensitivity of the infrared sensor can be increased as compared with conventional sensors by using a pyroelectric material comprising VDF oligomer having a pyroelectric coefficient higher than that of an inorganic ferroelectric material or a ferroelectric polymer which has been used on many pyroelectric infrared sensors and a substrate comprising a polymer film having heat capacity and heat conductivity lower than those of conventional substrates made of Si or the like.

When the pyroelectric infrared sensor of the present invention is formed into a cylindrical shape or a spherical shape, an angle of visibility of 360° can be obtained.

When the pyroelectric infrared sensor of the present invention is provided with means for changing a curvature, since a focus of a surface receiving infrared rays can be moved, a location of heat source can be determined by measuring a change in intensity of infrared rays while moving the focus.

Also, the same function as that of conventional optical chopper can be obtained by repeating this change in curvature (by oscillating). Namely, when a curvature of the substrate is changed, since a distance between the VDF oligomer layer and the heat source (source of infrared rays) changes, a temperature change can be generated in the VDF oligomer layer even in the case of a stationary heat source, and a temperature can be measured. Though an optical chopper has been used to give a temperature change with respect to stationary heat source, when means for changing a curvature is provided on the pyroelectric infrared sensor of the present invention and a change in curvature is repeated by such means, a temperature of the stationary heat source can be measured without using an optical chopper.

Example of means for changing a curvature is a substrate having a bimorph configuration using two piezoelectric polymer films. In this case, a curvature can be changed by changing a voltage to be applied between these two piezoelectric polymer films. In addition, by applying ac voltage, the substrate oscillates, which makes it possible to use the sensor as a sensor for measuring temperature of stationary heat source without using such an optical chopper as mentioned above.

When at least either an upper electrode or a lower electrode is formed into a plurality of pieces, an infrared sensor array having a plurality of pyroelectric infrared sensors corresponding to a plurality of electrodes can be formed on one substrate. By using such an infrared sensor array, a speed and an acceleration speed of an object releasing infrared rays can be measured, for example, by a difference in change with time of intensity of infrared rays of each sensor.

When the portions of the substrate between the above-mentioned plural electrodes are eliminated, heat conduction among the plural pyroelectric infrared sensors formed on the substrate can be inhibited, and detection accuracy of each sensor can be increased.

In the case where the substrate is transparent to an aimed infrared ray and a surface of the substrate corresponding to at least any of a plurality of electrodes is formed into a shape of a condensing lens, when the VDF oligomer layer is irradiated with infrared rays from the surface of substrate, the infrared rays are condensed in a narrow region inside the VDF oligomer layer by means of the condensing lens, thereby generating a large temperature change of VDF oligomer in such a region and enabling detection accuracy of infrared rays to be improved.

### BRIEF DESCRIPTION OF DRAWINGS

[Fig. 1] A cross-sectional view of one embodiment of the pyroelectric infrared sensor of the present invention
[Fig. 2] A cross-sectional view showing an example of the pyroelectric infrared sensor of the present invention provided with a plurality of lower electrodes and/or upper electrodes
[Fig. 3] A cross-sectional view showing an example of a process for production of the pyroelectric infrared sensor of the present invention
[Fig. 4] A perspective view showing an example of a pyroelectric infrared sensor formed into a cylindrical shape
[Fig. 5] A cross-sectional view showing an example of a pyroelectric infrared sensor having a curved substrate
[Fig. 6] A plan view and a cross-sectional view showing an example of a pyroelectric infrared sensor having curving means
[Fig. 7] A cross-sectional view showing an example of an infrared sensor for temperature measurement requiring no optical chopper
[Fig. 8] A plan view and a cross-sectional view showing an example of a pyroelectric infrared sensor array in which there are provided substrate-less portions on a boundary of each element
[Fig. 9] A cross-sectional view showing an example of a pyroelectric infrared sensor array in which convex portions are provided on the VDF oligomer layer
[Fig. 10] A graph showing results of measurement of induced charge of the pyroelectric infrared sensors of the present invention and comparative example

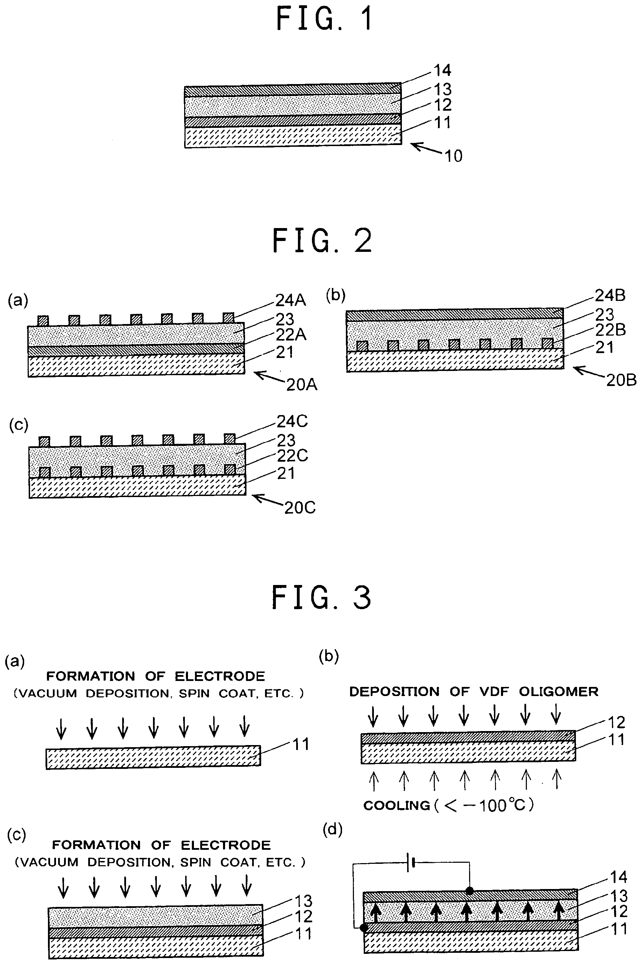

Examples of the pyroelectric infrared sensor of the present invention are explained by means of Fig. 1 to Fig. 10.

### (1) Basic structure of the pyroelectric infrared sensor of the present invention

Fig. 1 is a cross-sectional view of the pyroelectric infrared sensor 10 having a basic structure of the present invention. This pyroelectric infrared sensor 10 is comprised of the substrate 11 comprising a polymer material, the lower electrode 12, the VDF oligomer layer 13 and the upper electrode 14 which are laminated in this order.

For the substrate 11, a sheet of polymer material such as polyimide or polyethylene having a thickness of 5 to 200 µm is used. For the VDF oligomer layer 13, a VDF oligomer represented by the chemical formula CF₃-(CH₂CF₂)ₙ-CₘH₂ₘ₊₁ where n is 5 to 50 and m is 1 to 10, or a substance obtained by replacing its CₘH₂ₘ₊₁ group by halogen atom is used. For the lower electrode 12 and the upper electrode 14, the above-mentioned metal deposition film, carbon deposition film or organic electrode is used. The lower electrode 12 and the upper electrode 14 are formed all over the surface of the substrate 11, and by making thicknesses thereof thin enough, the whole sensor can be made flexible.

A functional sequence of this pyroelectric infrared sensor 10 is the same as that of conventional pyroelectric infrared sensors. When the sensor is irradiated with infrared rays, a temperature of the VDF oligomer layer 13 is increased, and in proportion to a degree of this temperature change, an amount of polarization of the VDF oligomer changes. Incidence of infrared rays into the VDF oligomer layer 13 is detected by detecting a change in voltage between the lower electrode 12 and the upper electrode 14 which is generated by this change in polarization.

In this pyroelectric infrared sensor 10, any of its component elements, that is, the substrate 11, the lower electrode 12, the VDF oligomer layer 13 and the upper electrode 14 have flexibility, and the sensor does not have a component element being free from flexibility like a supporter made of Si and described in, for example, JP2000-155050A. Therefore, the sensor can be formed into a desired shape. In addition, the substrate 11 of this pyroelectric infrared sensor 10 is made of a polymer material and has heat capacity and heat conductivity which are lower than those of a substrate and supporter made of Si or the like. Therefore, detection accuracy of infrared rays can be increased.

### (2) Structure of pyroelectric infrared sensor having lower electrodes and/or upper electrodes divided into a plurality of pieces

Fig. 2 represents cross-sectional views of (a) the pyroelectric infrared sensor 20A, (b) the pyroelectric infrared sensor 20B, and (c) the pyroelectric infrared sensor 20C provided with a plurality of divided upper electrodes and/or lower electrodes. In any of these sensors, the substrates 21 are in the form of one sheet like the above-mentioned pyroelectric infrared sensor 10. In (a), only the upper electrode 24A is divided into a plurality of pieces, in (b), only the lower electrode 22B is divided into a plurality of pieces, and in (c), both of the lower electrode 22C and the upper electrode 24C are divided into a plurality of pieces.

In these pyroelectric infrared sensors 20A, 20B and 20C, by using each of divided upper electrodes 24A or 24C and/or divided lower electrodes 22B or 22C, a voltage of the VDF oligomer layer 23 provided directly on or under the respective electrodes can be measured. Accordingly, incidence of infrared rays into the VDF oligomer layer 23 can be detected independently by each electrode. Namely, the whole pyroelectric infrared sensor 20A, 20B or 20C forms a sensor array.

In these pyroelectric infrared sensors 20A, 20B and 20C, the electrodes 22A and 24B which are not divided need to have flexibility, but the divided upper electrodes 24A and 24C and the divided lower electrodes 22B and 22C do not need to have flexibility. Since there are spaces among the divided electrodes, the divided upper electrodes and the divided lower electrodes collectively have flexibility as a whole, and thus the sensors 20A, 20B and 20C have flexibility. Therefore, the three examples shown in Fig. 2 belong to the technical category of the present invention.

### (3) Process for production of the pyroelectric infrared sensor of the present invention

Fig. 3 shows an example of a process for production of the pyroelectric infrared sensor of the present invention. First, a polymer material sheet is prepared as the substrate 11, and the lower electrode 12 is formed on its surface (a). For forming the lower electrode 12, for example, when an electrode made of metal or carbon is used, a vacuum vapor deposition method can be employed, and when an organic electrode is used, a wet method such as a spin coat method can be employed.

Next, the substrate 11 having the lower electrode 12 formed thereon is cooled to -100°C or lower, and the VDF oligomer layer 13 is formed on the lower electrode 12 by a vacuum vapor deposition method (b). By this cooling, molecular chains of the VDF oligomer can be oriented in the direction parallel with the substrate, and by such an orientation structure, a state of easily exhibiting ferroelectric property and pyroelectric property can be obtained.

Thereafter, the cooling is terminated, and the upper electrode 14 is formed on the VDF oligomer layer 13 (c). Lastly, an electric field is formed in a vertical direction to the VDF oligomer layer 13 by applying dc voltage or ac voltage between the lower electrode 12 and the upper electrode 14 (d). As mentioned above, since the molecular chains of the VDF oligomer are oriented in the direction parallel with the substrate, the electric field is applied in a vertical direction to the molecular chains. The direction of polarization of the VDF oligomer is vertical to the molecular chains, and by this application of the electric field, spontaneous polarization is formed in the VDF oligomer layer 13 in a vertical direction to this layer (poling). The pyroelectric infrared sensor 10 is completed by the above-mentioned treatments.

When producing the pyroelectric infrared sensors shown in Fig. 2(a) to (c) which have the upper electrodes 24A or 24C and/or the lower electrodes 22B or 22C, in the steps of Fig. 3(a) and/or 3(c), vacuum vapor deposition may be carried out using a mask perforated at positions corresponding to the divided electrodes to be formed.

In the step of Fig. 3(d), an electric field may be applied to the VDF oligomer layer 13 by using an electrode for poling treatment instead of application of an electric field by connecting the upper electrodes and the lower electrodes to power source.

### (4) Example of the pyroelectric infrared sensors of the present invention having a changed form

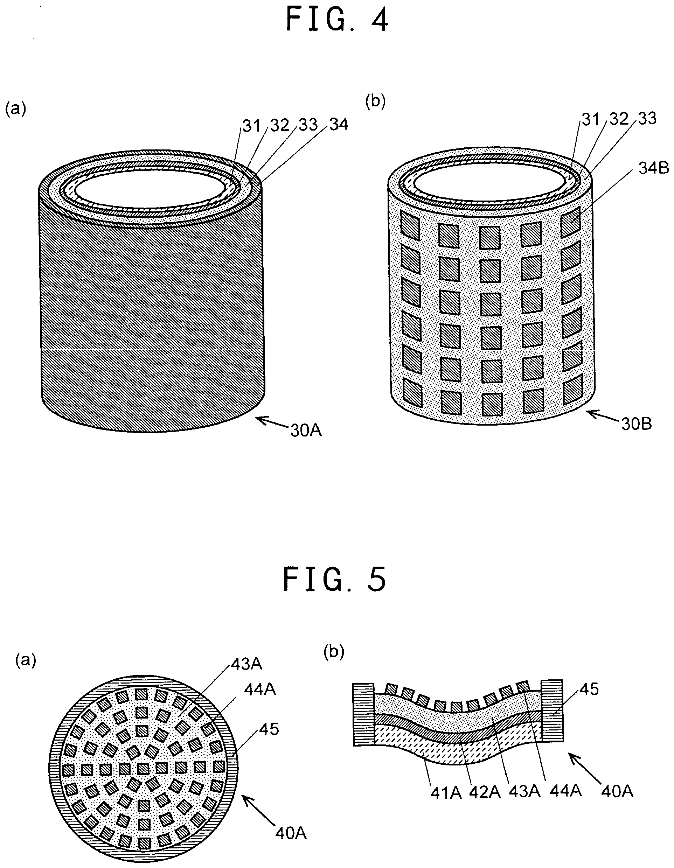

Fig. 4 shows examples of a pyroelectric infrared sensor formed into a cylindrical shape. The pyroelectric infrared sensor 30A shown in (a) is one obtained by forming the pyroelectric infrared sensor 10 shown in Fig. 1 into a cylindrical form, and the lower electrode 32 and the upper electrode 34 are provided all over the surface in one body, respectively. The pyroelectric infrared sensor 30B shown in (b) is one obtained by forming the pyroelectric infrared sensor 20A shown in Fig. 2(a) into a cylindrical form, and the lower electrode 32 is provided all over the surface in one body and the upper electrode 34B is divided into a plurality of pieces. The both sensors have the substrate 31 on an inner side of the cylinder, and the VDF oligomer layer 33 on an outer side of the cylinder. Those sensors detect an infrared ray radiator located outside the cylinder.

The cylindrical pyroelectric infrared sensors 30A and 30B can detect all incident infrared rays coming from all directions around the periphery thereof. In addition, in the case of the pyroelectric infrared sensor 30B having the divided electrodes, a direction of an existing infrared ray source and a motion thereof can be determined by measuring a change in voltage between each of the plural upper electrodes 34B and the lower electrode 32 and specifying distribution of detected intensity.

Fig. 4 shows an example of the sensor having the substrate 31 on an inner side of the cylinder and the VDF oligomer layer 33 on an outer side of the cylinder. On the contrary, the substrate 31 may be located on an outer side of the cylinder, and the VDF oligomer layer 33 may be located on an inner side of the cylinder. For example, when such a sensor is so arranged as to enclose a dropping route or a flying route of a small product (work), it can be used as a sensor for detecting movement of the work, its speed and deviation from a regular route. A liquid or gas passage may be provided inside the cylinder, and by providing such a passage, the sensor can be used as a sensor for detecting a temperature change of liquid or gas flowing through the passage.

Fig. 5 shows a curved pyroelectric infrared sensor 40A obtained by curving the pyroelectric infrared sensor 10 of Fig. 1. Fig. 5(a) is a plan view of the curved pyroelectric infrared sensor 40A, and Fig. 5(b) is cross-sectional views thereof. This curved pyroelectric infrared sensor 40A is obtained by forming the substrate 41A into a nearly circular shape and fixing a circumference thereof with a rigid ring 45. The lower electrode 42A and the VDF oligomer layer 43A are in the form of one sheet, and the upper electrode 44A is a divided electrode.

In this curved pyroelectric infrared sensor 40A, as the focus formed by a curved surface of the curved VDF oligomer layer 43A is approached to a point light source, a difference in an amount of incident infrared ray among the divided electrodes becomes smaller. By making use of this, a location of the point light source can be estimated by measuring an amount of incident infrared ray while moving the curved pyroelectric infrared sensor 40A (namely, moving the above-mentioned focus), and determining a position where the difference in the amount of incident light in each of the divided electrodes becomes minimum.

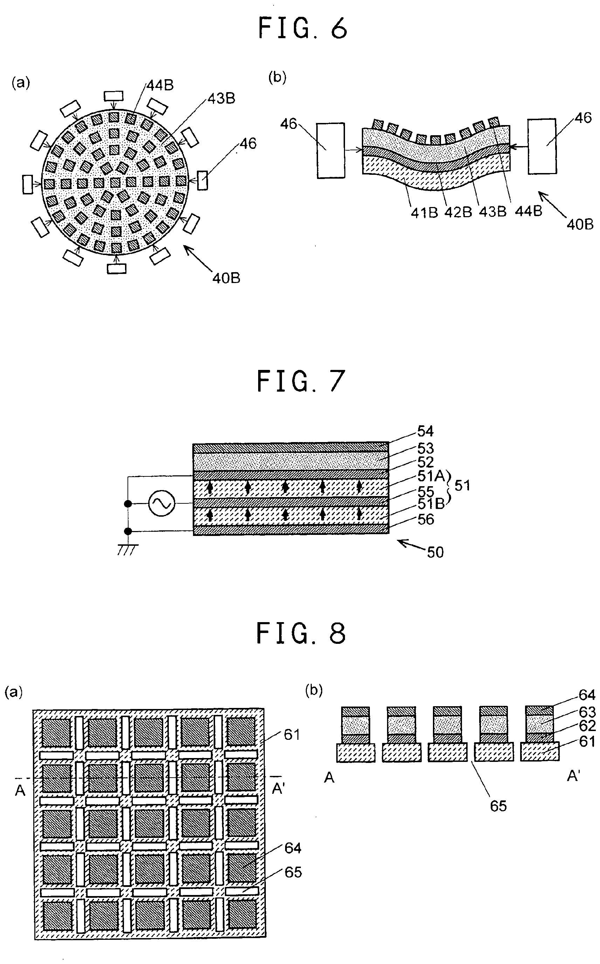

Fig. 6 shows the pyroelectric infrared sensor 40B having means for changing a curvature. (a) is a plan view of the pyroelectric infrared sensor 40B, and (b) is a cross-sectional view showing the pyroelectric infrared sensor 40B being in a curved state. In this example, for the substrate 41B, the lower electrode 42B, the VDF oligomer layer 43B and the upper electrodes 44B, the same ones as in the curved pyroelectric infrared sensor 40A are used. The curving means comprises a plurality of actuators 46 arranged around the substrate 41B. Each of the actuators 46 presses the substrate 41B from its circumference toward its center. By adjusting this pressing force of the actuator 46, curvatures of the substrate 41B, the lower electrode 42B, the VDF oligomer layer 43B and the (whole) upper electrodes 44B can be changed. When the pressing force of the actuator 46 is decreased, a curvature naturally decreases by a restoring force of the substrate 41B itself.

When the curvature of the substrate 41B is changed, a focus formed by a curved surface of the VDF oligomer layer 43B changes. Accordingly, a location of the point light source can be estimated in the same manner as in the curved pyroelectric infrared sensor 40A by measuring an amount of incident infrared ray while changing the curvature, namely changing a position of the focus, and determining a position where the difference in a measured amount of incident infrared ray among all the divided electrodes becomes minimum.

In addition, an amount of incident infrared ray into the VDF oligomer layer 43B just under each of the divided electrodes can be periodically changed by periodically changing a curvature of the VDF oligomer layer 43B, etc. by using the actuator 46.

When measuring a temperature of stationary heat source with an infrared sensor, in order to generate pyroelectric current, so far temperature change with time has been given to the pyroelectric material by giving change with time of an amount of incident infrared rays by repeating switching on and off of incidence of infrared rays with an optical chopper. According to the method of example of the present invention, change with time of an amount of incident infrared rays can be given without using an optical chopper.

### (5) Example of infrared sensor for measuring temperature without using an optical chopper

Next, another example of a pyroelectric infrared sensor for measuring temperature without using an optical chopper is explained by means of Fig. 7. In this pyroelectric infrared sensor 50, the substrate 51 is comprised of polymer films 51A and 51B comprising a piezoelectric material polarized in a vertical direction to the substrate and a flexible oscillation control electrode 55 provided between these films. Under the substrate 51 is provided a flexible grounding electrode 56. On the substrate 51 are provided the lower electrode 52, the VDF oligomer layer 53 and the upper electrode 54 in the same manner as in the pyroelectric infrared sensor 10. The oscillation control electrode 55 and the lower electrode 52 are connected to the ac power source 57, and the oscillation control electrode 55 and the grounding electrode 56 are connected to the ac power source 57 so that the lower electrode 52 and the grounding electrode 56 are grounding side electrodes, respectively. These polymer films 51A and 51B, oscillation control electrode 55, grounding electrode 56 and lower electrode 52 form a piezoelectric bimorph. The lower electrode 52 is used also for measuring voltage between the upper electrode 54 and the lower electrode 52 which is generated due to temperature change of the VDF oligomer layer 53 in the same manner as in the pyroelectric infrared sensor 10.

In this pyroelectric infrared sensor 50, when ac voltage is applied between the oscillation control electrode 55 and the lower electrode 52 and between the oscillation control electrode 55 and the grounding electrode 56 by using the ac power source 57, the polymer film 51A and the polymer film 51B undergo shrinkage and expansion in opposite phase in parallel with the films due to a piezoelectric effect. By this, the substrate 51, the VDF oligomer layer 53 provided thereon, etc. oscillate in a direction vertical to them. Since by this oscillation, a distance between the VDF oligomer layer 53 and the heat source changes without interruption, even in the case of incidence of infrared rays from a stationary heat source, temperature change with time can be given to the VDF oligomer layer 53. Therefore in the pyroelectric infrared sensor 50, temperature of stationary heat source can be measured without using an optical chopper.

### (6) Example of pyroelectric infrared sensor thermally separated in an array of infrared sensor units

Fig. 8 shows a top view (a) and a cross-sectional view (b) showing another example of a pyroelectric infrared sensor divided to the same form comprising an upper electrode, a lower electrode and a VDF oligomer layer provided between them. In this pyroelectric infrared sensor 60, pyroelectric infrared sensor units are formed by the upper and lower electrodes and the VDF oligomer layer provided between them, and the whole pyroelectric infrared sensor is composed of an array of these pyroelectric infrared sensor units. In this pyroelectric infrared sensor 60, the substrate 61 is eliminated between the adjacent pyroelectric infrared sensor units (substrate-less region 65), and the substrates are connected only at a point of intersection of the four infrared sensor units, thus maintaining the whole infrared sensor united in one body. In the present invention, since a polymer material is used on the substrate, a part of the substrate 61 can be easily eliminated by solvent treatment using masking or by mechanical cutting. By this, each of infrared sensor units constituting the array can be thermally separated nearly perfectly, and detection accuracy of each infrared sensor unit can be increased.

### (7) Example of pyroelectric infrared sensor having condensing lens on its substrate

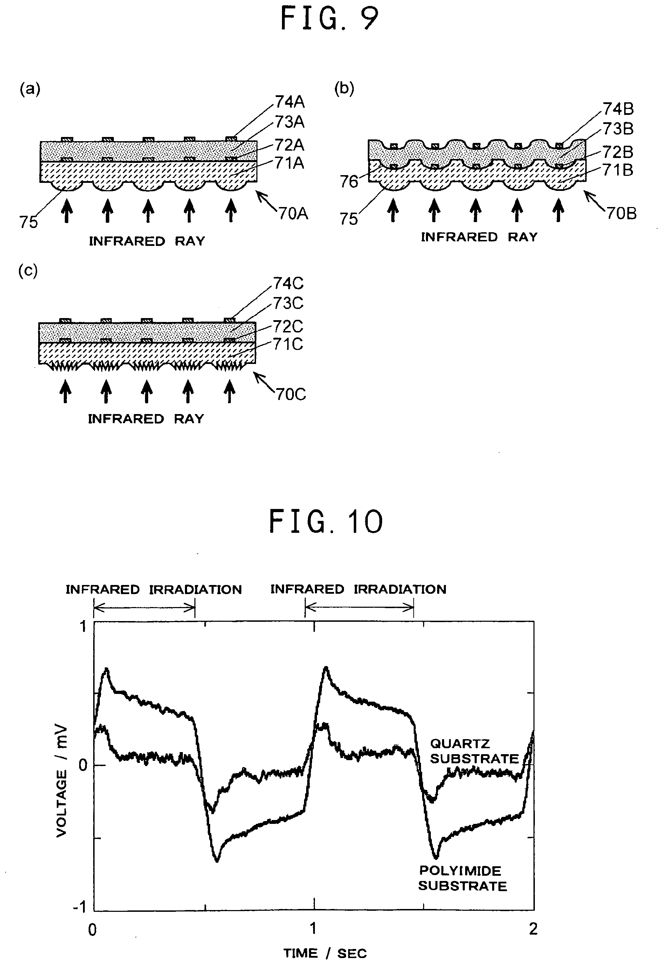

Fig. 9 shows pyroelectric infrared sensors 70A to 70C having, on their substrates 71, many condensing lenses facing outward. In the pyroelectric infrared sensors 70A and 70B, a plurality of convex portions 75 made of the same material as that of the substrate and facing outward are formed on the surfaces of the substrates 71A and 71B on the outer side of the sensor. Further, in the pyroelectric infrared sensor 70B, concave portions 76 corresponding to the convex portions 75 and facing inward of the substrate 71B are formed on the surface of the substrate 71B at the side of VDF oligomer layer 73B, and also the VDF oligomer layer is formed into a convex form toward the substrate 71B, and for fitting to the concave portion, the VDF oligomer layer 73B is also formed in a convex shape toward the substrate 70B. In the pyroelectric infrared sensor 70C, a plurality of Fresnel lenses 77 comprising many saw teeth concentrically formed are formed.

These substrates 71A to 71C are made of a material through which aimed infrared rays pass. Any of the lower electrodes 72A to 72C and the upper electrodes 74A to 74C comprise divided electrodes arranged corresponding to the convex portions 75 or Fresnel lenses 77.

In these pyroelectric infrared sensors 70A to 70C, by letting infrared rays enter from the substrate 71 side, the infrared rays are condensed into a narrower region by the convex portions 75 or Fresnel lenses 77 as compared with the case of using neither convex portions 75 nor Fresnel lenses 77, and therefore, a large temperature change of the VDF oligomer occurs in such a region and detection accuracy of infrared rays is increased.

Fig. 10 shows results of measurement of induced charge of the pyroelectric infrared sensor 10 which is induced on the VDF oligomer layer at the time of irradiation of infrared rays (switching OFF to ON) and at the time of stopping irradiation of infrared rays (switching ON to OFF), and the results are shown by voltage. In this experiment, polyimide was used on the substrate 11, and Cr was used on the lower electrode 12 and the upper electrode 14. Fig. 10 also shows the results of similar measurements as a comparative example with respect to a pyroelectric infrared sensor using quartz substrate instead of a polyimide substrate. In this experiment, infrared ray released from a blackbody furnace (500°C) was used. In Fig. 10, an abscissa represents time. From the results of this experiment, it was found that in both of the switching OFF to ON and the switching ON to OFF, an absolute value of output voltage is larger and response is quicker in Example of the present invention as compared with Comparative Example.

### INDUSTRIAL APPLICABILITY

In the present invention, since the substrate made of a polymer material and the VDF oligomer layer have flexibility and also the upper electrode and the lower electrode are made of materials having flexibility, the pyroelectric infrared sensor of the present invention has flexibility. By making use of such flexibility, pyroelectric infrared sensors formed into a shape suitable for an installation site or desired shapes such as a curved shape, a cylindrical shape and a spherical shape can be obtained.

## Claims

1. A pyroelectric infrared sensor (10, 20A-C, 30A-B, 40A-B, 50, 60, 70A-C) having flexibility and comprising:
a) a substrate (11) comprising a polymer material,
b) a layer (13) of vinylidene fluoride oligomer being formed on said substrate and comprising CF₃-(CH₂CF₂)ₙ-CₘH₂ₘ₊₁ (n=5 to 50, m=1 to 10) or a substance obtained by replacing its CₘH₂ₘ₊₁ group by halogen atom,
c) a lower electrode (12) having flexibility and being formed between the substrate and the vinylidene fluoride oligomer layer, and
d) an upper electrode (14) having flexibility and being formed on said vinylidene fluoride oligomer layer.

2. The pyroelectric infrared sensor of (30A-B) Claim 1, **characterized by** being formed into a curved shape.

3. The pyroelectric infrared sensor of (30A-B) Claim 1, **characterized by** being formed into a cylindrical shape.

4. The pyroelectric infrared sensor of Claim 1, **characterized by** being formed into a spherical shape.

5. The pyroelectric infrared sensor (40A-B) of any of Claims 1 to 4, **characterized by** having means for changing a curvature (45, 46).

6. The pyroelectric infrared sensor of Claim 5, wherein said substrate (50) has a bimorph configuration (51, 52, 55 and 56) comprising two sheets (51A and 51B) of piezoelectric polymer films.

7. The pyroelectric infrared sensor (20A-C, 30B, 40A-B, 60, 70A-C) of any of Claims 1 to 6, wherein at least either said upper electrode or lower electrode is divided into plural pieces.

8. The pyroelectric infrared sensor (60) of Claim 7, wherein portions of said substrate between a plurality of electrodes are eliminated.

9. Thepyroelectric infrared sensor of Claim 7 or 8, wherein said substrate (70A-C) is transparent to an aimed infrared ray, and a surface of the substrate corresponding to at least any of a plurality of electrodes is formed into a shape of a condensing lens.

## Patentansprüche

1. Pyroelektrischer Infrarotsensor (10, 20A-C, 30A-B, 40AB, 50, 60, 70A-C), der Flexibilität aufweist und umfasst:
a) ein Substrat (11), das ein Polymermaterial umfasst,
b) eine Schicht (13) aus einem Vinylidenfluoridoligomer, die auf dem Substrat ausgebildet ist und CF₃-(CH₂CF₂)ₙ-CₘH₂ₘ₊₁ (n=5 bis 50, m=1 bis 10) oder eine Substanz, die durch Ersetzen der CₘH₂ₘ₊₁-Gruppe davon durch ein Halogenatom erhalten wird, umfasst,
c) eine untere Elektrode (12), die Flexibilität aufweist und zwischen dem Substrat und der Vinylidenfluoridoligomer-Schicht ausgebildet ist, und
d) eine obere Elektrode (14), die Flexibilität aufweist und auf der Vinylidenfluoridoligomer-Schicht ausgebildet ist.

2. Pyroelektrischer Infrarotsensor (30A-B) gemäß Anspruch 1, **dadurch gekennzeichnet, dass** er in eine gebogene Form geformt ist.

3. Pyroelektrischer Infrarotsensor (30A-B) gemäß Anspruch 1, **dadurch gekennzeichnet, dass** er in eine zylindrische Form geformt ist.

4. Pyroelektrischer Infrarotsensor gemäß Anspruch 1, **dadurch gekennzeichnet, dass** er in eine sphärische Form geformt ist.

5. Pyroelektrischer Infrarotsensor (40A-B) gemäß mindestens einem der Ansprüche 1 bis 4, **dadurch gekennzeichnet, dass** er Mittel zur Änderung einer Krümmung (45, 46) aufweist.

6. Pyroelektrischer Infrarotsensor gemäß Anspruch 5, worin das Substrat (50) eine bimorphe Konfiguration (51, 52, 55 und 56) aufweist, die zwei Bögen (51A und 51B) piezoelektrischer Polymerfilme umfasst.

7. Pyroelektrischer Infrarotsensor (20A-C, 30B, 40A-B, 60, 70A-C) gemäß mindestens einem der Ansprüche 1 bis 6, worin mindestens entweder die obere Elektrode oder die untere Elektrode in mehrere Teile geteilt ist.

8. Pyroelektrischer Infrarotsensor (60) gemäß Anspruch 7, worin Abschnitte des Substrats zwischen einer Vielzahl von Elektroden eliminiert sind.

9. Pyroelektrischer Infrarotsensor gemäß Anspruch 7 oder 8, worin das Substrat (70A-C) für einen gerichteten Infrarotstrahl transparent ist und eine Oberfläche des Substrats, die mindestens einer von einer Vielzahl von Elektroden entspricht, in die Form einer Kondensorlinse geformt ist.

## Revendications

1. Capteur infrarouge pyroélectrique (10, 20A-C, 30A-B, 40A-B, 50, 60, 70A-C) ayant une flexibilité et comprenant :
a) un substrat (11) comprenant un matériau polymérique,
b) une couche (13) d'oligomère de fluorure de vinylidène étant formée sur ledit substrat et comprenant CF₃-(CH₂CF₂)ₙ-CₘH₂ₘ₊₁ (n=5 à 50, m=1 à 10) ou une substance obtenue en remplaçant son groupe CₘH₂ₘ₊₁ par un atome d'halogène,
c) une électrode inférieure (12) ayant une flexibilité et étant formée entre le substrat et la couche d'oligomère de fluorure de vinylidène, et
d) une électrode supérieure (14) ayant une flexibilité et étant formée sur ladite couche d'oligomère de fluorure de vinylidène.

2. Le capteur infrarouge pyroélectrique (30A-B) de la revendication 1, **caractérisé en ce qu'**il est formé en une forme incurvée.

3. Le capteur infrarouge pyroélectrique (30A-B) de la revendication 1, **caractérisé en ce qu'**il est formé en une forme cylindrique.

4. Le capteur infrarouge pyroélectrique de la revendication 1, **caractérisé en ce qu'**il est formé en une forme sphérique.

5. Le capteur infrarouge pyroélectrique (40A-B) de l'une quelconque des revendications 1 à 4, **caractérisé en ce qu'**il a des moyens pour change de courbure (45, 46).

6. Le capteur infrarouge pyroélectrique de la revendication 5, dans lequel ledit substrat (50)a une configuration bimorphe (51, 52, 55 et 56) comprenant deux feuilles (51A et 51B) de films de polymère piézoélectrique.

7. Le capteur infrarouge pyroélectrique (20A-C, 30B, 40A-B, 60, 70A-C) de l'une quelconque des revendications 1 à 6, dans lequel au moins soit ladite électrode supérieure ou ladite électrode inférieure est divisée en plusieurs pièces.

8. Le capteur infrarouge pyroélectrique (60) de la revendication 7, dans lequel des portions dudit substrat entre une pluralité d'électrodes sont éliminés.

9. Le capteur infrarouge pyroélectrique de la revendication 7 ou 8, dans lequel ledit substrat (70A-C) est transparent à un rayonnement infrarouge visé, et une surface du substrat correspondant à au moins l'une quelconque d'une pluralité d'électrodes est formée en une forme d'une lentille condensatrice.
